# EUROPÄISCHE PATENTSCHRIFT

(11) **EP 1 151 534 B1**
(45) Veröffentlichungstag und Bekanntmachung des Hinweises auf die Patenterteilung: **30.10.2002**
(21) Anmeldenummer: 00910514.9
(22) Anmeldetag: 01.02.2000
(51) Int. Cl.: H03G 3/20

(54) **VERFAHREN UND ANORDNUNG ZUR LEISTUNGSREGELUNG EINES SENDEVERSTÄRKERS**
METHOD AND ARRANGEMENT FOR REGULATING THE POWER OF A TRANSMIT AMPLIFIER
PROCEDE ET DISPOSITIF POUR REGULER LA PUISSANCE D'UN AMPLIFICATEUR D'EMISSION

(30) Priorität: 11.02.1999 DE 19905730
(43) Veröffentlichungstag der Anmeldung: 07.11.2001
(73) Patentinhaber: SIEMENS AKTIENGESELLSCHAFT, 80333 München (DE)
(72) Erfinder: SALZMANN, Eugen, D-85402 Kranzberg (DE)
(86) Internationale Anmeldenummer: DE0000303
(87) Internationale Veröffentlichungsnummer: WO00048311

(56) Entgegenhaltungen:
- EP-A- 0 412 392
- EP-A- 0 472 330
- EP-A- 0 509 733
- EP-A- 0 546 693
- US-A- 5 126 686
- US-A- 5 423 081

## Beschreibung

Die Erfindung betrifft ein Verfahren und eine Anordnung zur Leistungsregelung eines Sendeverstärkers, insbesondere eines Sendeverstärkers eines Mobilfunkendgerätes.

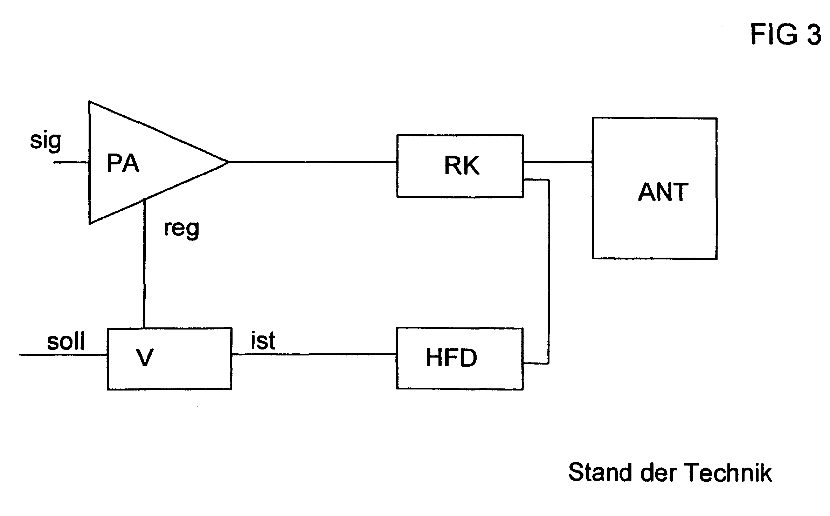

Figur 3 zeigt ein Prinzipschaltbild einer herkömmlichen Anordnung zur Leistungsregelung eines Sendeverstärkers PA. Die dem Sendeverstärker PA zugeführten zu verstärkenden Signale sig werden gemäß einem dem Sendeverstärker PA zugeführten Regelparameter reg, der ein Maß für die Verstärkung oder den Verstärkungsgrad/faktor darstellt, verstärkt und einem Richtkoppler RK zugeführt. Der Richtkoppler RK koppelt einen kleinen Teil der von dem Sendeverstärker PA der Antenne ANT zugeführten Leistung aus und führt sie einem Hochfrequenzdetektor HFD zu, der diese Leistung in eine Gleichspannung umwandelt. Dieser derart erzeugte Gleichspannungswert wird als Istwert ist einer Vergleichseinrichtung V zugeführt und dort mit einem durch eine Steuereinrichtung, wie beispielsweise einem Mikrocontroller eines Mobilfunkendgerätes, vorgegebenen Sollwert soll verglichen. Als Ergebnis des Vergleichs wird ein Regelparameter reg ausgegeben, der die Verstärkung des Sendeverstärkers PA so einstellt, daß der Istwert ist dem Sollwert soll entspricht. Dazu wird der Verstärkungsfaktor entsprechend der Differenz zwischen Soll- und Istwert erhöht oder erniedrigt. Der größere Teil der Leistung wird von dem Richtkoppler RK der Antenne ANT zugeführt, von der diese Leistung in Form hochfrequenter Signale abgestrahlt wird. Derartige herkömmliche Leistungsregelschleifen für einen Sendeverstärkers funktionieren gut in einem kleinen vorgegebenen Leistungsbereich.

Allerdings können moderne Mobilfunkendgeräte zur Verbesserung der Spektrumsausnutzung und zur Erhöhung der Betriebszeit des Mobilfunkengerätes in unterschiedlichen Sendeleistungsstufen betrieben werden. So können beispielsweise GSM (Global System for Mobile Communication) - Mobilfunkendgeräte je nach Leistungsklasse des Mobilfunkendgerätes in ihrer Sendeleistung innerhalb eines Bereichs von 20 und 30 dB variiert werden. Ausserdem muss die Sendeleistung von in einem Zeitschlitzbetrieb arbeitenden Mobilfunkendgeräten, wie beispielsweise GSM-Mobilfunkendgeräten entsprechend einer vorgegebenen Zeitschlitzstruktur geregelt werden. Dabei ist es insbesondere wichtig, zur Erzeugung eines Sendepulses (Burst) den Sendeverstärker gemäß einer fest vorgegebenen Soll-Zeit-Leistungskurve einzustellen (Power Ramping), was ebenfalls eine hohe Leistungsdynamik erfordert.

Diese beiden Anforderungen an die Leistungsregelung eines Sendeverstärkers können durch herkömmliche Verfahren oder Anordnungen nicht mehr zuverlässig erfüllt werden. Insbesodere die zuverlässige Leistungsdetektion durch einen HF-Detektor ist über einen weiten Leistungsbereich kaum mit einfachen Mitteln zu realisieren. Eine weitere Verschärfung dieser Problematik ergibt sich bei einer Leistungsregelung eines Multiband- bzw. Multimode-Mobilfunkendgerätes, da dabei die Anzahl der Sendeleistungsstufen weiter erhöht wird und unterschiedliche Soll-Zeit-Leistungskurven vorgegeben sein können. Auch zukünftige CDMA-Mobilfunkendgeräte werden eine Sendeleistungsregelung über einen sehr großen Leistungsbereich erfordern.

Daher liegt der Erfindung die Aufgabe zugrunde, ein Verfahren und eine Anordnung zur Leistungsregelung eines Sendeverstärkers anzugeben, die es ermöglichen, die Leistungsregelung einfach und dennoch zuverlässig in einem großen Leistungsbereich zu ermöglichen.

Diese Aufgabe wird durch die unabhängigen Patentansprüche gelöst. Vorteilhafte Weiterbildungen ergeben sich aus den Unteransprüchen.

Erfindungsgemäß wird ein Teil der von einem Sendeverstärker ausgegebenen Leistung mittels eines Koppelelementes ausgekoppelt und bei einer gewünschten Sendeleistung, die unter einem vorgegebenen Grenzwert liegt, zusätzlich mittels einer gesteuerten Schalteinrichtung ein weiterer Teil der Leistung ausgekoppelt und die ausgekoppelte Leistung zur Regelung des Sendeverstärkers verwendet.

Die Erfindung beruht demnach auf dem Gedanken, in einem ersten Fall, in dem die gewünschte Sendeleistung über einem bestimmten Grenzwert liegt, einen relativ geringen Teil der Leistung mittels eines Koppelelementes auszukoppeln und diesen geringen Teil zur Leistungsregelung des Sendeverstärkers zu verwenden. In einem zweiten Fall, in dem die gewünschte Sendeleistung unter einem bestimmten Grenzwert liegt, wird zusätzlich über eine Schalteinrichtung ein relativ großer Teil der vom Sendeverstärker abgegebenen Leistung ausgekoppelt und zur Leistungsregelung des Sendeverstärkers verwendet.

Dadurch wird erreicht, dass in beiden Fällen der Absolutwert der ausgekoppelten Leistung zumindest eine ähnliche Größenordnung aufweist, und so die Bauteile, die zur Weiterverarbeitung der ausgekoppelten Leistung in einen Regelparameter für den Sendeverstärker verwendet werden, insbesondere der Hochfrequenzdetektor in einem relativ kleinen Bereich betrieben werden können, und damit die Leistungsregelung zuverlässiger und mit weniger Aufwand gewährleistet werden kann.

Im Folgenden wird die Erfindung anhand von Ausführungsbeispielen, zu deren Erläuterung die nachfolgend angeführten Figuren dienen, näher erläutert:
- Figur 1: Prinzipschaltbild einer Ausführungsform einer Anordnung zur Leistungsregelung eines Sendeverstärkers;
- Figur 2: Prinzipschaltbild einer Ausführungsform einer Anordnung zur Leistungsregelung eines Sendeverstärkers;
- Figur 3: Prinzipschaltbild einer herkömmlichen Anordnung zur Leistungsregelung eines Sendeverstärkers.

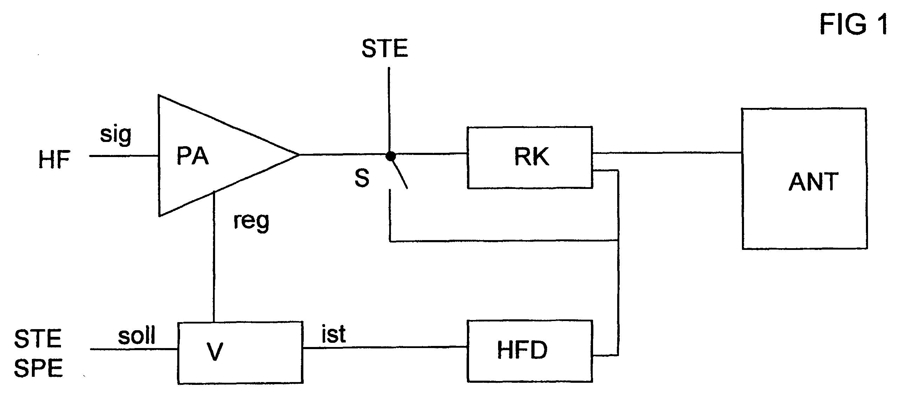

Figur 1 zeigt einen Sendeverstärker PA, der die Signale sig, die beispielsweise von dem Hochfrequenzteil HF eines Mobilfunkendgerätes ausgegeben werden, gemäß einem ebenfalls dem Sendeverstärker PA zugeführten Regelparameter reg verstärkt, und mit einer diesem Regelparameter reg entsprechenden Leistung ausgibt.

In einem ersten Fall, in dem die gewünschte Sendeleistung, beispielsweise die gewünschte Leistungsstufe oder die maximale vom Sendeverstärker oder der Antenne abzugebende Leistung bei Betrieb des Mobilfunkendgerätes in dieser Leistungsstufe, über einem vorgegebenen Grenzwert liegt, wird die durch eine Steuereinrichtung STE, wie beispielsweise dem Mikrocontroller eines Mobilfunkendgerätes, gesteuerte Schalteinrichtung S, die beispielsweise durch einen Transistor realisiert sein kann, geöffnet, so dass nur ein relativ kleiner Teil der vom Sendeverstärker PA abgegebenen Leistung durch ein Koppelelement, wie beispielsweise einem Richtkoppler RK ausgekoppelt wird und einem Leistungsdetektor, wie beispielsweise einem Hochfrequenzdetektor HFD zugeführt wird. Der Hochfrequenzdetektor kann auch mittels einer Diode oder eines Transistors realisiert sein. Der andere relativ große Teil der Leistung wird einer Antenne ANT zugeführt, von der sie abgestrahlt wird. Der Hochfrequenzdetektor HFD wandelt die ausgekoppelte Leistung in ein Gleichspannungssignal um, das als Istwert ist einer Vergleichseinrichtung V, die durch eine Differenzverstärkerschaltung realisiert sein kann, zugeführt wird. Dieser Istwert ist wird dort mit einem Sollwert soll verglichen, wobei als Ergebnis des Vergleichs ein Regelparameter reg ausgegeben wird, der derart eingestellt ist, dass die von dem Sendeverstärker ausgegebenen Signale eine Leistung aufweisen, die der gewünschten Sendeleistung entspricht; dies ist der Fall, wenn der Sollwert soll dem Istwert ist entspricht.

Der Sollwert soll entspricht dabei dem momentan gewünschten Leistungswert einer Soll-Zeit-Leistungskurve, die in einer Speichereinrichtung SPE, beispielsweise einem ROM-Speicher abgelegt sein kann und durch die Steuereinrichtung STE, wie beispielsweise einem Mikrocontroller eines Mobilfunkendgerätes ausgewählt, ausgelesen und eventuell angepasst oder verarbeitet werden kann. Der entsprechende Wert wird dann als Sollwert soll der Vergleichseinrichtung V zugeführt.

Bei einem zweiten Fall, in dem die gewünschte Sendeleistung unter einem vorgegebenen Grenzwert liegt, wird die gesteuerte Schalteinrichtung S geschlossen und ein relativ großer Teil der vom Sendeverstärker PA abgegebenen Leistung durch die Schalteinrichtung S ausgekoppelt. Diese ausgekoppelte Leistung wird zusammen mit dem relativ kleinen, eventuell vernachlässigbaren Anteil der durch den Richtkoppler RK ausgekoppelten Leistung dem Hochfrequenzdetektor HFD zugeführt und nach einer Umwandlung in eine Gleichspannung als Istwert ist der Vergleichseinrichtung V zugeführt.

Bei geschlossener Schalteinrichtung S wird ein wesentlich größerer Absolutwert der Leistung zur Leistungsregelung ausgekoppelt und kann daher nicht der Antenne zugeführt werden. Um der Antenne weiter die gewünschte Sendeleistung zuzuführen, wird die Verstärkung durch den Sendeverstärker entsprechend erhöht. Die Berücksichtigung der Schalterstellung der Schalteinrichtung S kann zu diesem Zweck auch folgendermaßen erfolgen: Entweder geschieht die Bestimmung des Sollwertes soll auf der Basis unterschiedlicher, aus der Speichereinrichtung SPE ausgelesener Soll-Zeit-Leistungskurven, oder auf der Basis einer einheitlichen Soll-Zeit-Leistungskurve, die nach dem Auslesen der entsprechenden Werte durch die Steuereinrichtung STE entsprechend der Schalterstellung weiterverarbeitet und angepasst werden.

Bei Einsatz der Erfindung in einem Multimode- oder Multibandendgerät kann die Anpassung der Leistungsregelung an die aktuelle Leistungsstufe oder die aktuelle Soll-Zeit-Leistungskurve ebenfalls durch die Auswahl der entsprechenden Soll-Zeit-Leistungskurve oder die Anpassung einer einheitlichen Soll-Zeit-Leistungskurve durch die Steuereinrichtung erfolgen.

Um eine klare Darstellung der Ausführungsbeispiele zu erreichen, wurde in den Zeichnungen auf Duplexer, Diplexer, Anpass- oder Wandlerschaltungen verzichtet.

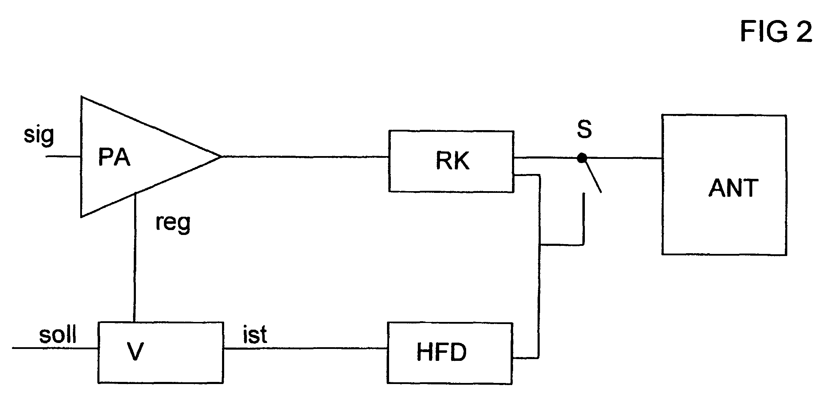

Figur 2 zeigt eine Ausführungsvariante der Erfindung, die sich von dem in Figur 1 dargestellten Ausführungsbeispiel im Wesentlichen darin unterscheidet, dass die gesteuerte Schalteinrichtung S nicht zwischen Sendeverstärker PA und Koppelelement RK angeordnet ist, sondern zwischen Koppelelement RK und Antenne ANT. Die Funktionsweise der beiden Ausführungsvarianten ist dabei im Wesentlichen gleich.

## Patentansprüche

1. Verfahren zur Leistungsregelung eines Sendeverstärkers (PA), bei dem
- ein erster Teil der von einem Sendeverstärker (PA) abgegebenen Leistung vor der Zuführung an eine Antenne (ANT) mittels eines Richtkopplers (RK) ausgekoppelt wird,
- bei einer gewünschten Sendeleistung, die unter einem vorgegebenen Grenzwert liegt, zusätzlich mittels einer gesteuerten Schalteinrichtung (S), deren Eingang zwischen Sendeverstärker (PA) und Richtkoppler(RK) oder zwischen Richtkoppler (RK) und der Antenne (ANT) liegt, und deren Ausgang zwischen Richtkoppler (RK) und Mitteln (HFD, V, PA) zur Regelung der Leistung des Sendeverstärkers liegt, ein zweiter Teil der vom Sendeverstärker (PA) abgegebenen Leistung ausgekoppelt wird, und
- ein von der insgesamt ausgekoppelten Leistung abhängiges Signal zur Einstellung des Verstärkungsfaktors des Sendeverstärkers (PA) verwendet wird.

2. Verfahren nach Anspruch 1, bei dem
einer Vergleichseinrichtung (V) ein von der insgesamt ausgekoppelten Leistung abhängiges Signal zugeführt wird,
der Vergleichseinrichtung (V) ein einer Soll-Leistung entsprechender Wert (soll) zugeführt wird, welcher in Abhängigkeit von der Stellung der Schalteinrichtung (S) ermittelt wird, und
das Vergleichsergebnis (reg) zur Einstellung des Verstärkungsfaktors des Sendeverstärkers (PA) verwendet wird.

3. Anordnung zur Leistungsregelung eines Sendeverstärkers (PA), mit
- einem Richtkoppler (RK) zum Auskoppeln eines Teils der von einem Sendeverstärker (PA) abgegebenen Leistung vor der Zuführung an eine Antenne (ANT),
- einer gesteuerten Schalteinrichtung (S), deren Eingang zwischen Sendeverstärker (PA) und Richtkoppler (RK) oder zwischen Richtkoppler (RK) und der Antenne (ANT)liegt, und deren Ausgang zwischen Richtkoppler (RK) und Mitteln (HFD, V, PA) zur Regelung der Leistung des Sendeverstärkers liegt, zum zusätzlichen Auskoppeln eines Teils der von einem Sendeverstärker abgegebenen Leistung für den Fall, daß die gewünschte Sendeleistung unter einem vorgegebenen Grenzwert liegt, und
- Mitteln (HFD, V, PA) zur Regelung der Leistung des Sendeverstärkers (PA) in Abhängigkeit von der insgesamt ausgekoppelten Leistung.

4. Anordnung nach Anspruch 3 mit
einer Vergleichseinrichtung (V) zur Ausgabe eines Vergleichsergebnisses (reg) zur Einstellung des Verstärkungsfaktors des Sendeverstärkers (PA), der ein von der insgesamt ausgekoppelten Leistung abhängiges Signal und ein einer Soll-Leistung entsprechender Wert (soll) zugeführt wird, und
Mitteln (STE) zur Ermittlung eines der Soll-Leistung entsprechenden Wertes (soll) in Abhängigkeit von der Stellung der Schalteinrichtung (S).

## Claims

1. Method for controlling the power of a transmission amplifier (PA), in which
- a first portion of the power emitted from a transmission amplifier (PA) is output by means of a directional coupler (RK) before being supplied to an antenna (ANT),
- for a desired transmission power level, which is less than a predetermined limit value, a second portion of the power emitted from the transmission amplifier (PA) is additionally output by means of a controlled switching device (S), whose input is located between the transmission amplifier (PA) and the directional coupler (RK) or between the directional coupler (RK) and the antenna (ANT), and whose output is located between the directional coupler (RK) and means (HFD, V, PA) for controlling the power of the transmission amplifier, and
- a signal which is dependent on the total output power is used to set the gain factor of the transmission amplifier (PA).

2. Method according to Claim 1, in which
a comparison device (V) is supplied with a signal which is dependent on the total output power,
the comparison device (V) is supplied with a value (nom) which corresponds to a nominal power level and is determined as a function of the position of the switching device (S), and
the comparison result (reg) is used to set the gain factor of the transmission amplifier (PA).

3. Arrangement for controlling the power of a transmission amplifier (PA), having
- a directional coupler (RK) for outputting a portion of the power emitted from a transmission amplifier (PA), before it is supplied to an antenna (ANT),
- a controlled switching device (S), whose input is located between the transmission amplifier (PA) and the directional coupler (RK), or
between the directional coupler (RK) and the antenna (ANT), and whose output is located between the directional coupler (RK) and means (HFD, V, PA) for controlling the power of the transmission amplifier, for additionally outputting a portion of the power emitted from a transmission amplifier in the situation where the desired transmission power is less than a predetermined limit value, and
- means (HFD, V, PA) for controlling the power of the transmission amplifier (PA) as a function of the total output power.

4. Arrangement according to Claim 3, having
a comparison device (V) for outputting a comparison result (reg) for setting the gain factor of the transmission amplifier (PA), to which a signal which is dependent on the total output power and a value (nom) which corresponds to a nominal power level are supplied, and
means (STE) for determining a value (nom) which corresponds to the nominal power level, as a function of the position of the switching device (S).

## Revendications

1. Procédé destiné à réguler la puissance d'un amplificateur d'émission (PA), dans lequel
- une première partie de la puissance délivrée par un amplificateur d'émission (PA) est découplée, au moyen d'un coupleur directif (RK), avant l'application à une antenne (ANT),
- dans le cas d'une puissance d'émission souhaitée, qui est inférieure à une valeur seuil prédéterminée, une deuxième partie de la puissance délivrée par l'amplificateur d'émission (PA) est découplée en supplément au moyen d'un dispositif contrôlé de commutation (S), dont l'entrée se trouve entre l'amplificateur d'émission (PA) et le coupleur directif (RK) ou entre le coupleur directif (RK) et l'antenne (ANT) et dont la sortie se trouve entre le coupleur directif (RK) et des moyens (HFD, V, PA) destinés à la régulation de la puissance de l'amplificateur d'émission, et
- un signal, qui dépend de la puissance découplée au total, est utilisé pour le réglage du facteur d'amplification de l'amplificateur d'émission (PA).

2. Procédé selon la revendication 1, dans lequel
un signal, qui dépend de la puissance découplée au total, est appliqué à un dispositif de comparaison (V),
une valeur (soll), correspondant à une puissance de consigne et qui est déterminée en fonction de la position de commutation du dispositif de commutation (S), est appliquée au dispositif de comparaison (V) et
le résultat de la comparaison (reg) est utilisé pour le réglage du facteur d'amplification de l'amplificateur d'émission (PA).

3. Dispositif destiné à réguler la puissance d'un amplificateur d'émission (PA) comportant
- un coupleur directif (RK) destiné à découpler, avant son application à une antenne (ANT), une partie de la puissance délivrée par un amplificateur d'émission (PA),
- un dispositif contrôlé de commutation (S), dont l'entrée se trouve entre l'amplificateur d'émission (PA) et le coupleur directif (RK) ou entre le coupleur directif (RK) et l'antenne (ANT) et dont la sortie se trouve entre le coupleur directif (RK) et des moyens (HFD, V, PA) destinés à la régulation de la puissance de l'amplificateur d'émission, destiné à découpler en supplément une partie de la puissance délivrée par un amplificateur d'émission dans le cas où la puissance d'émission souhaitée est inférieure à une valeur seuil prédéterminée, et
- des moyens (HFD, V, PA) destinés à la régulation de la puissance de l'amplificateur d'émission (PA) en fonction de la puissance qui est découplée au total.

4. Dispositif selon la revendication 3 comportant
un dispositif de comparaison (V), destiné à délivrer un résultat de comparaison (reg) pour le réglage du facteur d'amplification de l'amplificateur d'émission (PA) et auquel sont appliqués un signal, qui dépend de la puissance découplée au total, et une valeur (soll) correspondant à une puissance de consigne et
des moyens (STE) destinés à déterminer une valeur (soll) correspondant à une puissance de consigne en fonction de la position du dispositif de commutation (S).
